# EUROPEAN PATENT APPLICATION

(11) **EP 3 923 368 A1**
(43) Date of publication of application: **15.12.2021**
(21) Application number: 20752681.5
(22) Date of filing: 15.01.2020
(51) Int. Cl.: H01M 2/10, F16J 15/10, H05K 5/06

(54) **SEAL STRUCTURE**

(30) Priority: 04.02.2019 JP 2019018235
(71) Applicant: NOK Corporation, Tokyo 105-8585 (JP)
(72) Inventor: ONO, Tasuku, Aso-shi, Kumamoto 869-2231 (JP)
(74) Representative: Global IP Europe Patentanwaltskanzlei
(86) International application number: PCT/JP2020/001051
(87) International publication number: WO 2020/162124

(57) **Abstract**

A sealing structure which can more simply and securely hold a gasket on an upper end of a side wall of a battery case as attached member is provided. The sealing structure 100 includes a gasket 110 arranged along an upper end side 11a of a side wall 11 of a battery case 10 and an attachment wall 120 fastened to the side wall 11 of the battery case 10. The gasket 110 includes a gasket main body 111 and a bulging sealing portion 112. The gasket main body 111 has an upper end 111a arranged higher than the upper end 11a of the side wall 11. The bulging sealing portion 112 is arranged on the exterior side of the upper end side of the gasket main body 111, and tightly contacts an inner peripheral surface 21b of an engagement portion 21 arranged on an outer edge of a cover 20 for covering an opening side of the battery case 10. The attachment wall 120 includes an accommodation portion 123 and an outer peripheral surface 120a. The accommodation portion 123 accommodates a lower side of the gasket main body 111 between the side wall 11 and the attachment wall 120. The outer peripheral surface 120a is arranged on the interior side with respect to the inner peripheral surface 21b of the engagement portion 21.

## Description

### FIELD

The present disclosure relates to a sealing structure.

### BACKGROUND

With the development of e-Mobility, battery case gaskets which seal against leakage from a gap between a battery case for accommodating a battery for vehicles (e.g., electric car) and a cover for covering the battery case are under development. The battery case gaskets have a long peripheral length and a large plan view shape corresponding to a size of such a battery case. For this reason, because it is difficult to form such a long battery case gasket by press forming, the battery case gasket is necessarily formed by extrusion.

Extruded parts which are formed by extrusion have a fixed shape along their peripheral length. Accordingly, in order to attach such a gasket, the extruded part is necessarily subjected to additional processing ,or a groove or the like for holding the gasket is additionally formed on a member to which the gasket is attached. An example of the related art of gasket attachment is provided by Japanese Patent Laid-Open Publication No. 2012-122536 which discloses a gasket of extruded part having through holes for bolt insertion. Another example is provided by Japanese Patent Laid-Open Publication No. 2017-172756 which discloses a sealing structure having a circular groove formed on a member to which the gasket is attached.

### BRIEF SUMMARY

### TECHNICAL PROBLEM

Additional processing in which through holes or the like are formed on the extruded part as gasket is laborious and increases its cost. On the other hand, in the case in which the member to which the gasket is attached is formed by press forming, a space on which a gasket attachment groove is formed cannot be sufficiently provided, or the member to which the gasket is attached is necessarily additionally subjected to additional processing in which a groove or the like is formed. For these reasons, a sealing structure is required to more simply and securely hold a gasket on an attached member such as battery case.

An object of the present disclosure is to provide a sealing structure which can more simply and securely hold a gasket on an attached member.

### SOLUTION TO PROBLEM

A sealing structure according to the present disclosure includes
a gasket arranged along an upper end side of a side wall of a battery case, the gasket including
   a gasket main body having an upper end arranged higher than the upper end of the side wall, and
   a bulging sealing portion arranged on the exterior side of the upper end side of the gasket main body, is the sealing portion configured to be in tight contact with an inner peripheral surface of an engagement portion arranged on an outer edge of a cover for covering an opening side of the battery case; and
an attachment wall fastened to the side wall of the battery case, the attachment wall including
   an accommodation portion accommodating a lower side of the gasket main body between the side wall and the attachment wall, and
   an outer peripheral surface arranged on the interior side with respect to the inner peripheral surface of the engagement portion.

### ADVANTAGEOUS EFFECTS

According to a sealing structure of the present disclosure, a gasket can be more simply and securely held on an attached member.

### BRIEF DESCRIPTION OF DRAWINGS

Fig. 1 is a plan view entirely showing the construction of a sealing structure according to an embodiment.
Fig. 2 is a perspective view showing the construction of a principal part of the sealing structure according to the embodiment.
Fig. 3 is a cross-sectional view showing the construction of a principal part of the sealing structure according to the embodiment.

### DETAILED DESCRIPTION

The following description will describe a sealing structure according to a preferred embodiment. It is noted that the scope of the present disclosure defined by claims attached hereto is not limited to the embodiment. Not all the components described in the description of the embodiment are essential components for the solution means of the present disclosure.

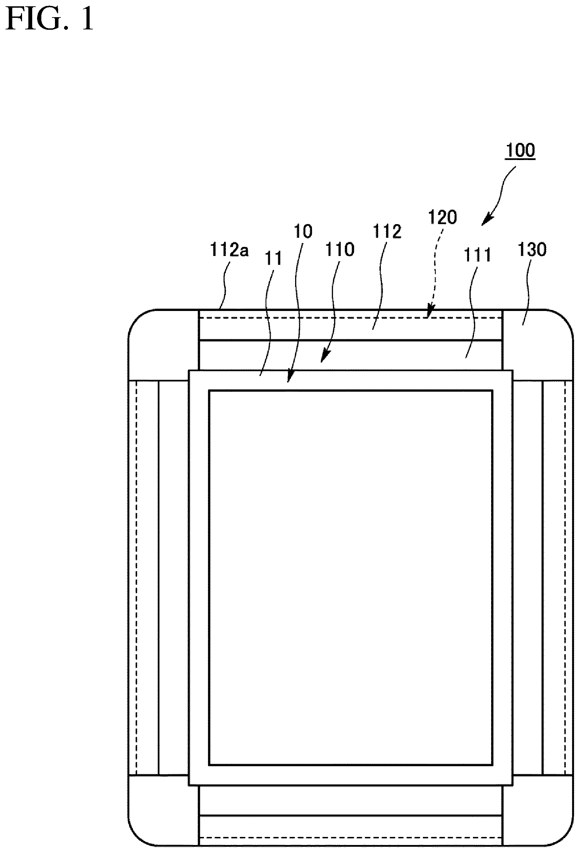

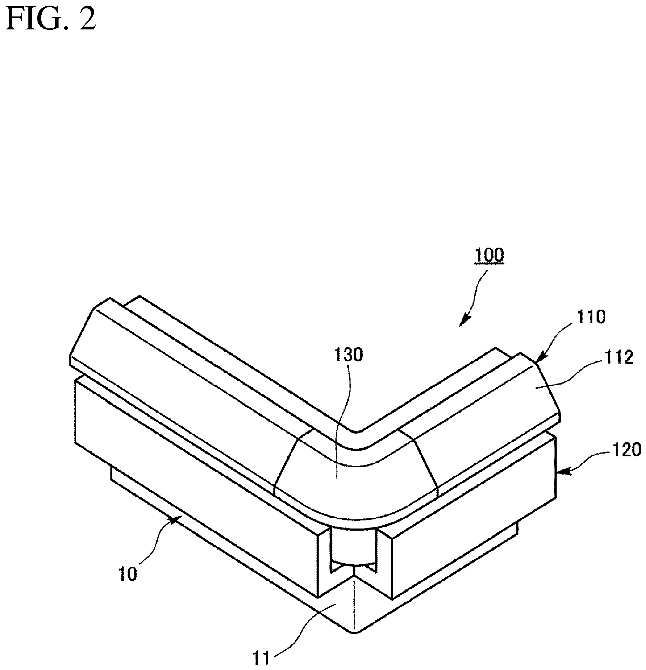

The schematic construction of a sealing structure according to an embodiment is first schematically described with reference to Figs. 1 and 2. Fig. 1 is a plan view showing the sealing structure according to this embodiment which is attached to the battery case. Fig. 2 is a perspective view showing a part of the sealing structure according to this embodiment including a coupling portion.

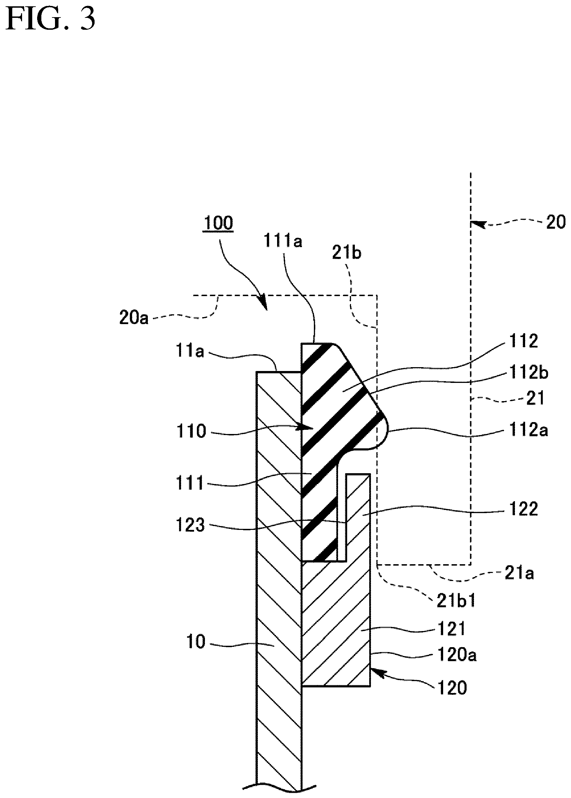

The sealing structure 100 is a gasket for a battery case which seals leakage from a gap between a battery case 10 and a covers 20 which covers the battery case 10 (see Fig. 3), for example. The battery case 10 accommodates a vehicle battery which is mainly used for vehicles such as electric car, fuel-cell car, and hybrid car. The sealing structure 100 according to this embodiment is arranged on an opening side of the battery case 10 as shown in Fig. 1. The sealing structure 100 includes a gasket 110, welded walls 120, and coupling portions 130.

The gasket 110 is held on the battery case 10. The gasket 110 provides hermeticity between the battery case 10 and the cover 20 (see Fig. 3). The gasket 110 is an extruded part which is formed of a rubber-like elastic material having a rubber hardness degree not higher than 70 by extrusion. Exemplary rubber-like elastic materials can be provided by a rubber material, a synthetic resin material having rubber-like elasticity, and the like.

The gasket 110 according to this embodiment includes gasket main bodies 111 which extend along their corresponding edge of the battery case 10 on the opening side as shown in Fig. 1. The gasket main bodies 111 have a liner elongated shape, and a fixed sectional shape along their entire length. The ends of the gasket main bodies 111 are fitted into the coupling portions 130 so that the gasket main bodies 111 are coupled to each other by the coupling portions 130. The coupling portions 130 are formed of rubber or the like. Accordingly, the gasket 110 has a rectangular frame shape.

The gasket 110 according to this embodiment is arranged along side walls 11 of the battery case 10 on their upper end sides as shown in Figs. 1 and 2. In addition, the gasket 110 includes sealing portions 112 on its upper end side which bulge outward. The sealing portions 112 will be brought in tight contact with the cover 20 which covers the opening side of the battery case 10 (see Fig. 3). The construction of the gasket 110 according to this embodiment will be discussed in more detail later.

The welded walls 120 are a bar-shaped member which is formed of metal such as steel and has an L shape as viewed in a cross section. The welded walls 120 are fastened onto the side walls 11 of the battery case 10 on their exterior sides. The welded walls 120 serve as an attachment wall which holds the gasket 110 and guides the cover 20. When the battery case 10 is covered by the cover 20, the welded walls 120 according to this embodiment are attached so that the outer peripheral surface 120a will be arranged on the interior side with respect to an inner peripheral surface 21b of an engagement portion 21 arranged on the outer edge of the cover 20 (see Fig. 3). The welded walls 120 according to this embodiment are fastened onto the side wall 11 of the battery case 10 by welding from the exterior side.

The construction of a principal part of the sealing structure according to this embodiment is now described with reference to Fig. 3. Fig. 3 is a cross-sectional view illustrating a positional relationship between the gasket and the welded wall of the sealing structure according to this embodiment which are attached to the battery case, and the cover taken along a line perpendicular to a length direction of the gasket main body.

The sealing structure 100 according to this embodiment achieves sealing performance mainly in the horizontal directions (interior-to-exterior directions) between the battery case 10 and the cover 20. As shown in Fig. 3, the metal welded walls 120 are fastened onto parts of the side walls 11 of the battery case 10 in proximity to their upper ends 11a by welding from the exterior side. Also, the gasket 110 which includes the sealing portion 112 configured to be in tight contact with the cover 20 for covering the opening side of the battery case 10 is held along the exterior sides of the upper ends 11a of the side walls 11 of the battery case 10 by the welded walls 120 which serve as the attachment wall.

The gasket 110 of this embodiment includes the gasket main bodies 111 which include the sealing portion 112 on their upper end side configured to be in tight contact with the inner peripheral surface 21b of the engagement portion 21 arranged the outer edge of the cover 20 as shown in Fig. 3. A lower end side of the gasket main body 111 is accommodated in an accommodation portion 123 which is arranged in the welded wall 120. That is, the gasket main body 111 of the gasket 110 according to this embodiment is formed as extruded part which includes the sealing portion 112 having an inclined surface 112b on the upper end side of the gasket main body 111 when being formed by extrusion so that the gasket main body 111 can be easily fastened along the upper end 11a of the side wall 11 of the battery case 10 by the welded wall 120 without any adhesive.

The sealing portion 112 has the inclined surface 112b having a width which increases from its upper end side to its lower end side as viewed in a cross section as shown in Fig. 3. An outer peripheral end 112a on the outer peripheral side of the sealing portion is arranged on the exterior side at least with respect to the outer peripheral surface 120a of the attachment wall 120. Also, the sealing portion 112 according to this embodiment faces the exterior side on the upper end side of the gasket main body 111, and in addition an upper end 111a of the gasket main body 111 in which the sealing portion 112 is formed is arranged higher than the upper end 11a of the side wall 11 of the battery case 10.

According to this arrangement, when the cover 20 is placed on the battery case 10, an end 21b1 of the inner peripheral surface 21b of the engagement portion 21 first contacts the inclined surface 112b of the sealing portion 112, and the ceiling surface 20a of the cover 20 then presses the upper end 111a of the gasket main body 111. Accordingly, a large part of the sealing portion 112 including the end 112a is compressed and elastically deformed. As a result, the sealing portion 112 according to this embodiment achieves good sealing performance to seal against leakage through a gap between the sealing portion 112 and the inner peripheral surface 21b of the engagement portion 21 by elastically deforming such a large part of the sealing portion 112.

The welded wall 120 serves as the attachment wall which is fastened onto the side wall 11 by welding from the exterior side so that the gasket 110 is held along the upper end side of the side wall 11 of the battery case (attached member) 10. The welded wall 120 according to this embodiment includes a holding portion 121 and a partitioning wall portion 122 as shown in Fig. 3. The holding portion 121 includes the accommodation portion 123 on its interior side which accommodates the gasket main body 111. The partitioning wall 122 is arranged on the exterior side of the holding portion 121, and supports the gasket main body 111. The welded wall 120 has an L shape as viewed in a cross section. That is, the welded wall 120 according to this embodiment has the accommodation portion 123 which accommodates the gasket 110 between the welded wall 120 and the side wall 11 of the battery case 10.

Also, the outer peripheral surface 120a of the welded wall 120 according to this embodiment is arranged on the interior side relative to the inner peripheral surface 21b of the engagement portion 21 of the cover 20. According to this arrangement, when the cover 20 covers the battery case 10, the welded wall 120 of this embodiment can guide the engagement portion 21 of the cover 20.

On the other hand, in this embodiment, when the engagement portion 21 of the cover 20 is guided by the welded walls 120, the cover 20 is not positioned in the height direction. For this reason, in order to surely provide hermeticity, it is necessary to prevent an excess load by the weight of the cover 20 applied to the upper end 11a of the side wall 11 of the battery case 10. To this end, in the sealing structure 100 of according to this embodiment, in order to surely achieve sealing performance in the vertical direction between the battery case 10 and the cover 20, the upper end 111a of the gasket main body 111 is arranged higher than the upper end 11a of the side wall 11 of the battery case 10.

Although the attachment walls of the sealing structure 100 according to this embodiment have been described to include the welded wall 120 which is fastened by welding, means for fastening the attachment wall onto the side wall 11 of the battery case 10 is not limited to welding. For example, in the case in which both the battery case and the attachment wall are formed of a rigid resin or the like, the attachment wall may be fastened onto the battery case by other fastening means such as adhesive or thermocompression bonding.

As discussed above, in the sealing structure 100 according to this embodiment, the welded wall 120 having a desired shape as the attachment wall for holding the gasket 110 are first fixedly attached onto the exterior part of the battery case (attached member) 10 in proximity to the upper ends 11a of the side walls 11 by welding, and the gasket 110 is then held by the welded walls 120. For this reason, the gasket 110 can be securely held on the side walls 11 of the battery case (attached member) 10 by a simple structure without additional processing in which fastening through holes, protrusions or the like are formed on the gasket 110 of extruded part formed by extrusion.

Also, according to the sealing structure 100 of this embodiment, the gasket 110 can be held in place and provide sealing effects without forming grooves or the like for holding the gasket 110 on the side walls 11 of the battery case 10 by presswork. For this reason, according to the sealing structure 100 of this embodiment, the gasket 110 of extruded part which is formed by extrusion is not necessarily subjected to additional processing, and grooves or the like for holding the gasket 110 are not required to be formed on the side walls 11 of the battery case 10 as the attached member to which the gasket is attached.

In addition, hermeticity in the horizontal directions of the battery case 10 and the cover 20 (i.e., between the outer peripheral surface on the upper end side the side wall 11 of the battery case 10 and the inner peripheral surface 21b of the engagement portion 21 of the cover 20) can be surely provided by a simple structure and simple method. As a result, in the case in which the sealing structure 100 according to this embodiment is applied to gaskets for battery cases to be used for vehicles such as electric cars, the workability and attachment performance of a gasket for battery cases can be improved. Therefore, the sealing structure 100 according to this embodiment has great value in industry.

Although the sealing structure of one embodiment has been described above in detail, it will be easily understood by a person skilled in the art that various changes can be made. For example, a term that is stated together with a different term used in a broader sense of the term or synonymous with the term at least once in the specification or the drawings can be replaced by the different term in other statements in the specification or the drawings. Also, the construction and operation of the sealing structure are not limited to the embodiment but various changes can be made.

### Reference Signs List

- 10: Battery Case
- 11: Side Wall
- 11a: Side Wall Upper End
- 20: Cover
- 20a: Ceiling Surface
- 21: Engagement Portion
- 21a: Engagement Portion Lower End
- 21b: Engagement Portion Inner Peripheral Surface
- 21b1: Inner Peripheral Surface Lower End
- 100: Sealing Structure
- 110: Gasket
- 111: Gasket Main Body
- 112: Sealing Portion
- 112a: Sealing Portion Outer Peripheral End
- 112b: Inclined Surface
- 120: Welded Wall (Attachment Wall)
- 120a: Welded Wall Outer Peripheral Surface
- 121: Holding Portion
- 122: Partitioning Wall
- 123: Accommodation Portion
- 130: Coupling Portion

## Claims

1. A sealing structure comprising:
a gasket arranged along an upper end side of a side wall of a battery case, the gasket including
a gasket main body having an upper end arranged higher than the upper end of the side wall, and
a bulging sealing portion arranged on the exterior side of the upper end side of the gasket main body, is the sealing portion configured to be in tight contact with an inner peripheral surface of an engagement portion arranged on an outer edge of a cover for covering an opening side of the battery case; and
an attachment wall fastened to the side wall of the battery case, the attachment wall including
an accommodation portion accommodating a lower side of the gasket main body between the side wall and the attachment wall, and
an outer peripheral surface arranged on the interior side with respect to the inner peripheral surface of the engagement portion.

2. The sealing structure according to claim 1, wherein the sealing portion has an inclined surface having a width increasing from its upper end side to its lower end side.

3. The sealing structure according to claim 1 or 2, wherein the outer peripheral end of the sealing portion is arranged on the exterior side at least with respect to the outer peripheral surface of the attachment wall.

4. The sealing structure according to any one of claims 1 to 3, wherein the attachment wall is a welded wall fastened onto the side wall of the battery case by welding.

5. The sealing structure according to any one of claims 1 to 4, wherein the gasket is an extruded part formed of a rubber-like elastic material having a rubber hardness degree not higher than 70.

6. The sealing structure according to any one of claims 1 to 5, wherein
the gasket includes a plurality of the gasket main bodies, and
the sealing structure further includes coupling portions that couple the plurality of gasket main bodies to each other.

7. The sealing structure according to any one of claims 1 to 6, wherein the gasket main body has a linear shape.
